# EUROPEAN PATENT SPECIFICATION

(11) **EP 1 229 642 B1**
(45) Date of publication and mention of the grant of the patent: **17.12.2008**
(21) Application number: 01102249.8
(22) Date of filing: 31.01.2001
(51) Int. Cl.: H03F 3/72, H03F 1/02

(54) **Power amplifier circuit for amplifying RF-Signals**
Leistungsverstärker zum Verstärken von Funksignalen
Amplificateur de puissance pour amplifier des signaux radiofréquences

(43) Date of publication of application: 07.08.2002
(73) Proprietor: Sony Deutschland GmbH, 10785 Berlin (DE)
(72) Inventor: Filinomov, Nicolai, Sony Inter. (Europe) GmbH, Heisenbergbogen 1, 85609 Aschheim (DE); Varlamov, Oleg, Sony International (Europe) GmbH, Heisenbergbogen 1, 85609 Aschheim (DE)
(74) Representative: Körber, Martin Hans

(56) References cited:
- EP-A- 0 837 559
- EP-A- 1 032 120

## Description

The present invention relates to a power amplifier circuit for amplifying an input RF-signal (radio frequency signal). It is particularly useful in the type of RF-signal power amplifiers used in wireless telephones.

Code Division Multiple Access (CDMA) modulation techniques are one of several techniques for facilitating communications in which a large number of system users are present. Although other techniques, such as time division multiple access (TDMA), frequency division multiple access (FDMA) are known, CDMA techniques have significant advantages over these other techniques. The CDMA techniques are used in many wireless telephone systems, such as IS-95, UMTS (with W-CDMA) and others.

In wireless telephone systems, a plurality of wireless telephones communicates with one or more base stations within "cells". In Code Division Multiple Access (CDMA) wireless telephone systems, in particular, wherein all portable users within a cell are sharing the same band of frequencies, but using different codes to modulate their respective signals, each wireless telephone transmitter signal becomes noise to all of the others. Keeping the overall noise level down tends to help all users. This is particularly true for UMTS, the W-CDMA standard. Wireless telephones are called upon to transmit at a wide range of power levels depending upon conditions existing at the time of transmission. A mobile W-CDMA phone is required to transmit at maximum power relatively seldom. For the greater part of the time it is better to transmit at relatively low power levels. When low power levels are required it is desirable that the current-consuming high-power stages be turned off and bypassed. Typically, W-CDMA wireless phones operate at a large number of discrete power levels; the levels are selected in response to changing transmission conditions.

The operating environment of a UMTS wireless telephone is typically urban or suburban. Both environments have common salient features: the probability of operating at high output power (such as more than 15 dBm), or at low output power (such as less than -15 dBm) is small. It is most probable that the power amplifier output power is in the neighbourhood of 0 - 10 dBm. Power amplifiers that are efficient at high output power (28 dBm) are usually not efficient at 5 dBm. The efficiency of class A amplifiers and class AB amplifiers tends to zero as the output power is reduced. High efficiency in the High Efficiency Power Amplifier sense refers to the average current drawn by the amplifier in a specified operating environment.

The cause of low efficiency in class A and class AB amplifiers at low output power is their idle or quiescent current. The level of quiescent current is chosen to satisfy the design requirements at maximum output power, but is typically still drawn from the supply when the power amplifier is not transmitting at maximum power. Since the power amplifier is seldom at maximum power the quiescent current is wasted most of the time.

A typical power amplifier consists of several serial stages. Each stage is usually larger, and more powerful than the previous one. Most of the quiescent current is drawn by latter high power stages, which are not required for the low output power levels at which the phone is often called upon to transmit. It follows that bypassing the high power stages when they are not required can make a significant saving in current.

Of course, the individual stages of a power amplifier add more than power, they add gain. Fortunately, the decrease in gain that accompanies bypassed stages is a bonus, as it decreases the dynamic range required by previous circuitry.

Since wireless telephones operate on battery power, it is also desirable that their transmitters operate as efficiently as possible to conserve power and extend battery life. Ideally for W-CDMA systems, such as those governed by the UMTS standard, power amplifier stages should be capable of efficient, linear operation over their required dynamic range. However, the prior art has not yet come close to the ideal and many wireless telephones are having poor power management now. During low power transmissions, power is wasted by cascaded amplifier stages that are not needed. Consequently, attempts have been made to bypass unused stages.

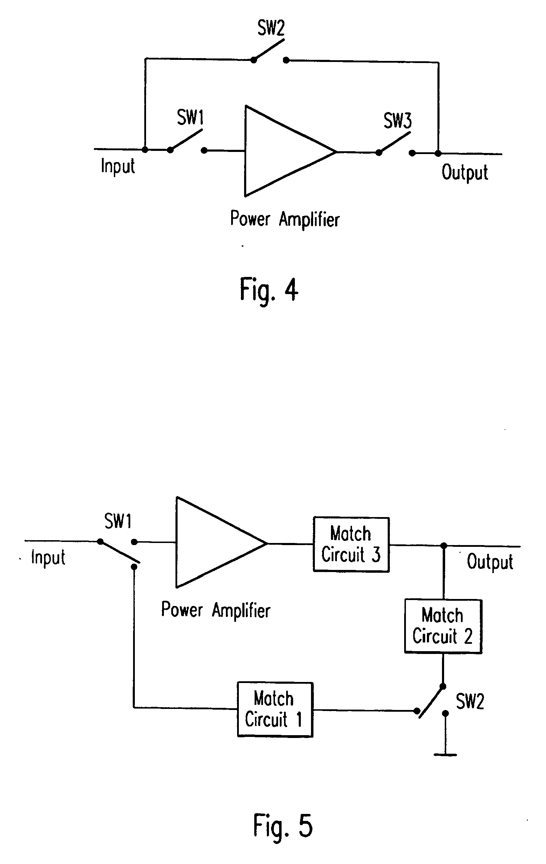

Such attempts have required the high power amplifiers output to pass through a switch. For example, see EP 1 032 120 and U.S. Pat. No. 5,661,434 issued August 26, 1997 to Brozovich et al. entitled "High Efficiency Multiple Power Level Amplifier Circuit". Brozovich et al. utilizes three single-pole single-throw switches to bypass stages of a multi-stage amplifier as shown in fig. 4. A bypass switch is always in series with the amplifier stage to be bypassed. However, it is difficult to utilize switches in series with high power amplifier stages. Generally, switches have a loss associated with them. Forcing the output of high power amplifier stages through a switch could cause an unacceptable loss. Furthermore, the types of switches that must be used for high power are both large and expensive, causing unacceptable design constraints.

In U.S. Pat. No. 6,069,526 issued May 30, 2000 to Ballantyne entitled "Partial or Complete Amplifier Bypass, the output bypass switch is eliminated. However, two switches with their losses remain in the signal path in the bypassing mode as shown in fig. 5.

It is therefore the object of the present invention, to provide a power amplifier circuit for amplifying RF-signals (radio frequency signals) comprising an amplification path for amplifying an input RF-signal and a bypass pass for bypassing an input RF-signal, which reduces the losses remain in the signal path in the bypassing mode in comparison to the prior art.

The above object is achieved by a power amplifier circuit for amplifying an input RF-signal, comprising an input terminal featuring a first wave impedance Z₁ for inputting a RF-signal, an amplification path comprising an amplification means for amplifying the input RF-signal, a bypass path for bypassing the amplification path, a control terminal for controlling the operation mode of the power amplifier circuit between an amplifying mode and a bypassing mode, so that the input RF-signal is either amplified by the amplification path in the amplifying mode or bypassed by the bypass path in the bypassing mode, and an output terminal featuring a second wave impedance Z₂ for outputting the amplified or bypassed RF-signal.

The bypass path comprises a first matching circuit for adapting an input RF-signal to a third wave impedance Z₃, a second matching circuit for adapting the RF-signal adapted to the third wave impedance Z₃ to the second wave impedance Z₂ and for outputting the RF-signal adapted to the second wave impedance Z₂ to the output terminal, and a first switch controlled by the control terminal for changing the third impedance Z₃ so, that the bypass path substantially does not affect the output RF-signal in the amplifying mode, whereby the first switch is so disposed, that it is outside of the signal path of the bypass path in the bypassing mode.

In the amplifying mode (high power mode), an input radio frequency signal (RF-signal) is amplified by the amplification path. In this mode, the bypass path does not influence the operation of the amplification path.

In the bypassing mode (low power mode), an input RF-signal passes the power amplifier by to the output terminal through the bypass path. The amplification path in this mode does not affect the bypass path operation at all.

According to the present invention, there is no need for a serial switch within the bypass path. This has the advantage, that in the bypassing mode signal losses of the bypass path are reduced in comparison with prior art; the bypassed RF-signal passes the bypass path without considerable changes in signal power. The second switch, which is disposed in the amplification path, does substantially influence the RF-signal in the amplifying mode, since the RF-signal is gained by the amplification means 4 after the second switch.

For carrying out the present invention, the first switch switches the RF-signal adapted to the third wave impedance Z₃ to signal ground in the amplifying mode and disconnects the RF-signal adapted to the third wave impedance Z₃ from signal ground in the bypassing mode. Thereby, the third wave impedance Z₃ is much larger than the first and the second wave impedance Z₁ and Z₂.

In one embodiment of the present invention, the matching circuits respectively comprise at a time a transformer and a quarter wave transmission line for adapting the wave impedances.

In another embodiment of the present invention, the matching circuits comprise respectively a quarter wave transmission line with a wave impedance of sqrt(Z₁*Z₃) and sqrt(Z₂*Z₃) (sqrt= square root) for adapting the wave impedances.

Advantageously, the input wave impedance (first wave impedance Z₁) is equal to the output wave impedance (second wave impedance Z₂) of the power amplifier circuit; e.g. Z₁=Z₂=50Ω. However it is also possible, that the power amplifier circuit according to the present invention operates as a impedance converter, for example featuring an input wave impedance (first wave impedance) of 50Ω and an output wave impedance (second wave impedance) of 75Ω.

The power amplifier circuit according to the present invention comprises a second switching means serial arranged in the amplification path controlled by the controlling means for connecting the amplification path to the input terminal in the amplifying mode and for disconnecting the amplification path from the input terminal in the bypassing mode.

Further, the power amplifier circuit comprises a third switching means controlled by the controlling means for connecting a power supply terminal to the amplification means in the amplifying mode and for disconnecting the power supply terminal from the amplification means in the bypassing mode. This has the advantage, that the power consumption of the amplification path tends to zero in the bypassing mode.

Further advantageously, the amplification path comprises a third matching circuit for adapting the output wave impedance of the amplification means to the second wave impedance Z₂ and for outputting the RF-signal to the output terminal.

The power amplify circuit according to the present invention is advantageously used in communication terminals for a wireless communication means like mobile phones in UMTS (Universal Mobile Telephone System).

In the following description, preferred embodiments of the present invention are explained in more detail in relation to the enclosed figures in which
figure 1 shows a schematic bloc diagram of the power amplifier circuit according to the present invention,
figure 2 shows a realization of the first and second matching circuit according to a first embodiment of the invention,
figure 3a shows a realization of the first and second matching circuit according to a second embodiment of the invention,
figure 3b shows a schematic representation of the equivalent circuit of the quarter wave transmission line of fig. 3a,
figure 4 shows a schematic representation of prior art according to document US 5,661,434, and
figure 5 shows a schematic representation of prior art according to document US 6,069,526.

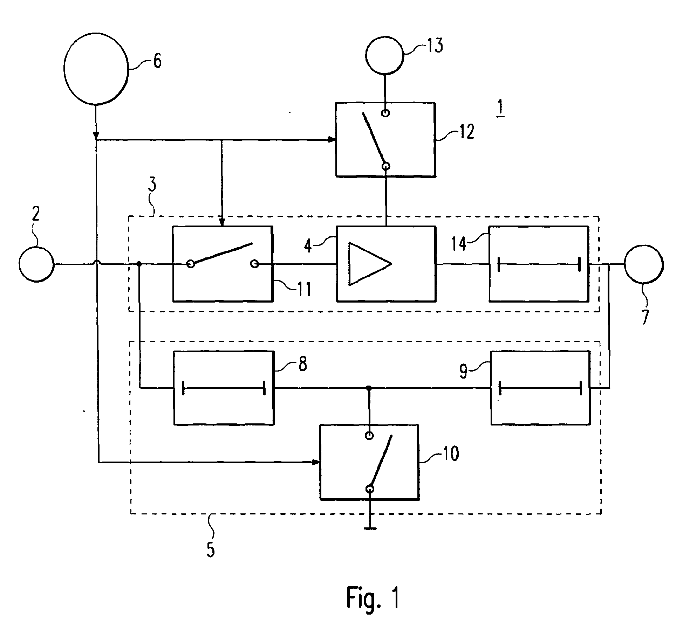

In Figure 1 the bloc diagram of an example of a power amplifier circuit 1 according to the present invention is shown. The power amplifier circuit 1 comprises basically the following units: a RF-input (input terminal 2), amplification means 4, control terminal 6, a RF-output (output terminal 7), first matching circuit 8, second matching circuit 9, first switch 10, second switch 11, third switch 12, power supply terminal 13 and third matching circuit 14.

The amplification path 3 comprises basically the second switch 11, amplification means 4 and third matching circuit 14. The bypass path 5 comprises basically the first and second matching circuit 8 and 9 and first switch 10.

A control means (not shown) is connected to the control terminal 6 for controlling the first, second and third switch 10, 11 and 12. For these purposes every switch comprises a control input at a time, which is connected at a time to the control terminal 6. The switches could for example realized by use of PIN-diodes as well as FET-transistors.

The input of the second switch 11 and the input of the first matching circuit 8 are connected to the input terminal 2. The output of the second switch 11 is connected to the input of the amplification means 4 and the output of the amplification means 4 is connected to the input of the third matching circuit 14, while the output of the third matching circuit 14 is connected to the output terminal 7.

The output of the first matching circuit 8 is connected to both the input of the second matching circuit 9 and the input of the first switch 10; the other input of the first switch 10 is shorted to ground. The output of the second matching circuit 9 is connected to the output terminal 7, the output of the third switch 12 is connected to the power input of the amplification means 4, and the input of the third switch 12 is connected to the power supply terminal 13. For supplying the power amplifier circuit 1 with power, a power supply (not shown) is connected to the power supply terminal 13.

It is also possible, to implement the third switch 12 into the amplification means 4. Since the third switch 12 switches DC-current power and no RF-signal, a low cost switch can be used.

The power amplifier circuit 1 according to the present invention operates in the following way:

In the amplifying mode (high power mode), an input radio-frequency signal is amplified by the amplification path 3, while the bypass path 5 in this mode does not influence the amplification path 3 operation. In the bypassing mode (low power mode), an input RF-signal passes to the power amplifier circuit 1 output through the bypass path 5 without considerable changes on signal power and the amplification path 3 in this mode does not affect the bypass path operation at all. Moreover, the consumption current of the amplification path 3 in the amplifying mode is equal to zero. As a result, when operating in the broad band of the required output power, a decrease in the average consumed current of the amplification means 4 is achieved.

To achieve a power consumption of the first, second and third switch 10, 11 and 12 and the amplification means 4 less than of that of the amplification means 4 in case of the amplification of an input signal to the level corresponding to the lower bound of the required output power in the amplifying mode, the first and second switch 10, 11 of the proposed power amplifier circuit 1 are opened in the bypassing mode. Therefore, with the technical realization of these switches using PIN-diodes as well as FET-transistors, their power consumption in the bypassing mode is equal to zero. Besides, the third switch 12 in the proposed power amplifier circuit 1 allows reducing the power consumption of the amplification means 4 to zero by means by switching off the power supply voltage from the amplification means 4 in the bypassing mode. Finally, the power consumption of the proposed power amplifier circuit 1 in the low power mode is equal to the power consumption of the third switch 12 in the turning off state of the amplifier means 4, and therefore it may be practically nullified.

The input and output impedance of the amplification path 3 in the bypassing mode should not considerably shunt the input and the output of the bypass path 5. This is achieved by the second switch 11 and the third matching circuit 14. The open second switch 11 prevents shunting the input of the bypass path 5 by the input impedance of the amplification path 3 in the bypassing mode. The third matching circuit 14 converts the output impedance of the amplification means 4 in turn-off state into the impedance that practically does not shunt the bypass path output. Such a matching circuit may be realized by a strip line segment with a characteristic wave impedance equal to the load impedance of the amplification means 4, and with a length that is adapted to convert the output impedance of the amplification means 4 in the turn-off state into an impedance that practically does not shunt the output of the bypass path 5. In this case, the third matching circuit 14 would not affect the amplification means 4 operation in the amplifying mode, since a strip line with the wave impedance equal to the load impedance has an input impedance equal to the load impedance.

In the bypassing mode, the gain should not significantly differ from 0dB, and in the amplifying mode, the input and the output impedance of the bypass path 5 should not considerably shunt the input and the output of the bypass path. This is achieved by the first and second matching circuit 8 and 9 on the one hand. They convert the low impedance of the closed first switch 10 into the high impedance that practically does not shunt the input and the output of the amplification path 3 in the amplifying mode. On the other hand, these matching circuits provide the 0dB gain of the cascade connection of the first and second matching circuit 8 and 9, when the first switch 10 is open (i.e. the bypass path 5 in the bypassing mode).

When the input and the output of the amplification path 3 are practically not shunted by the bypass path 5 in the amplifying mode, the gain of the amplification path 3 does not significantly differ from the gain of the amplification means 4. Further, stability conditions of the power amplify circuit 1 according to the present invention are satisfied.

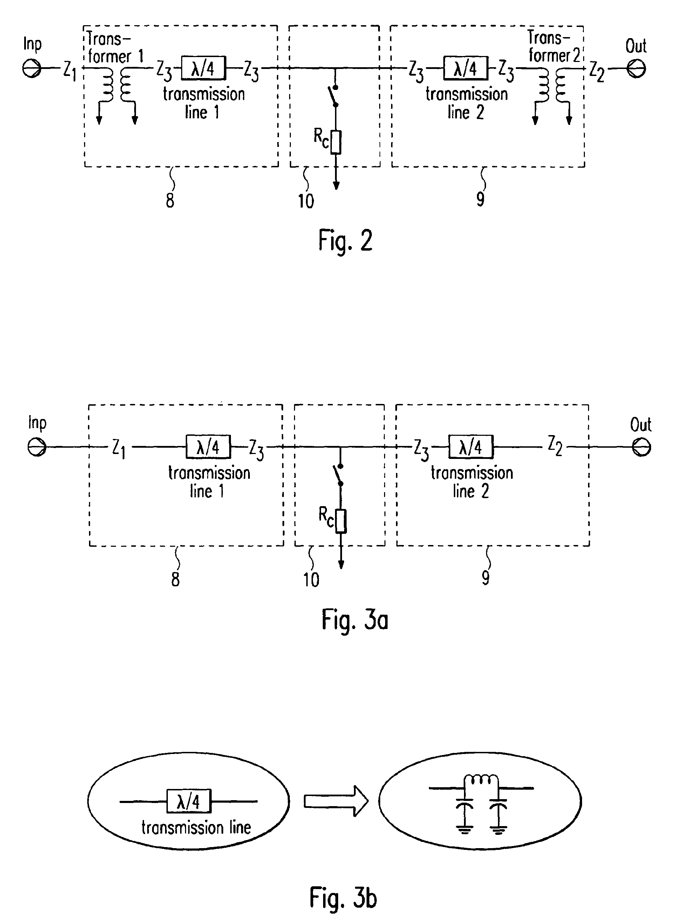

The operation of the bypass path 5 and the first and second matching circuit 8 and 9 is explained by the following examples in relation to figures 2 and 3a. In this examples, the first and second wave impedance Z₁ and Z₂ respectively are equal to 50Ω.

An idealized realization of a first bypass path design variant is shown in Fig. 2. This realization shows the structure of the first and second matching circuit 8 and 9 according to a first embodiment of the present invention.

The matching circuits 8 and 9 basically respectively comprises a transformer (transformer 1 and transformer 2) and a quarter wave transmission line (transmission line 1 and transmission line 2). In the bypassing mode, the first switch 10 is open and the bypass path represents a half-wave segment built of both quarter wave transmission lines with a wave impedance Z₃. The input of the first matching circuit 8 and the output of the second matching circuit 9 respectively are matched to the wave impedance of input terminal 2 and the output terminal 7 by means of appropriate transformers. This realization provides practically 0dB gain of the bypass path in the bypassing mode.

In the amplifying mode, the first switch 10 is closed and its impedance is equal to the closed switch impedance R_{C}. By means of the quarter-wave segments of the transmission lines transmission line 1 and transmission line 2, the third impedance Z₃ is converted into the third impedance Z₃' having a quantity of the order of (Z₃)²/R_{C}, which is then converted by means of the transformers into a quantity of the order of (Z₃*Z₁)/R_{C}, which is the impedance with which the bypass path shunts the amplification path in the amplifying mode; in the bypassing mode (first switch open), Z₃' is equal to Z₃. For example, for Z₃=1000Ω, Z₁=50Ω and R_{C}=5Ω, the bypass path shunts the amplification path in 10000Ω-order quantity.

In other words, closing the first switch 10 leads to a high reflection of the transmitted RF-signal at the point of the connection of the first switch 10 with the bypass path, whereby the reflection factor depends on R_{C}; the lesser the quantity of R_{C}, the higher the reflection. Closing the first switch 10 further leads to a standing electromagnetic wave of the RF-signal in the quarter wave segment of transmission line 1, which prevents reflection of the RF-signal back to the input terminal and therewith into the amplification path.

The above described operation of the first matching circuit 8 for the input RF-signal of the power amplifier circuit according to the present invention is the same as of the second matching circuit 9 for the output RF-signal. Thus, the second matching circuit 9 prevents the RF-signal output by the amplification path from being reflected by the bypass path.

However, such a large value of Z₃ as in the example may be hardly implemented in practice with transformers. Thus, as an alternative way, the second variant of the bypass path design is proposed as shown in figure 3a. This variant differs from the first one in the way, that there is no impedance transformer-converter (transformer 1 and transformer 2), and the impedance conversion task is solved by the corresponding choice of the wave impedance of the quarter-wave transmission lines (transmission line 1 and transmission line 2). This wave impedance of the quarter wave transmission lines is chosen by the formula Zₜ₁=sqrt(Z₁*Z₃) and Zₜ₁=sqrt(Z₂*Z₃), where Z₃ is the calculated wave impedance value at the point of connection of the first switch 10 with the bypass path and Zₜ₁ is the wave impedance of the quarter wave transmission line (transmission line 1 and transmission line 2). Under this conditions, the quarter wave transmission line 1 and quarter wave transmission line 2 may be realized using lumped elements as shown in Fig. 3b.

The operation of this second variant of bypass path implementation is absolutely identical with that of the first variant described above.

## Claims

1. Power amplifier circuit (1) for amplifying an input RF-signal, comprising
an input terminal (2) featuring a first wave impedance Z₁ for inputting a RF-signal,
an amplification path (3) comprising an amplification means (4) for amplifying the input RF-signal,
a bypass path (5) for bypassing the amplification path (3) ,
a control terminal (6) for controlling the operation mode of the power amplifier circuit (1) between an amplifying mode and a bypassing mode, so that the input RF-signal is either amplified by the amplification path (3) in the amplifying mode or bypassed by the bypass path (5) in the bypassing mode, and
an output terminal (7) featuring a second wave impedance Z₂ for outputting the amplified or bypassed RF-signal, whereby
the bypass path comprises
a first matching circuit (8) for adapting an input RF-signal to a third wave impedance Z₃,
a second matching circuit (9) for adapting the RF-signal adapted to the third wave impedance Z₃ to the second wave impedance Z₂ and for outputting the RF-signal adapted to the second wave impedance Z₂ to the output terminal (7), and
a first switch (10) controlled by the control terminal (6) for changing the third impedance Z₃ so, that the bypass path substantially does not affect the output RF-signal in the amplifying mode, whereby the first switch (10) is so disposed, that it is outside of the signal path of the bypass path in the bypassing mode.

2. Power amplifier circuit (1) according to claim 1,
**characterized in**
**that** the first switch (10) switches the RF-signal adapted to the third wave impedance Z₃ to signal ground in the amplifying mode and for disconnecting the RF-signal adapted to the third wave impedance Z₃ from signal ground in the bypassing mode.

3. Power amplifier circuit (1) according to claim 1 or 2,
**characterized in**
**that** the third wave impedance Z₃ is much larger than the first and the second wave impedance Z₁ and Z₂.

4. Power amplifier circuit (1) according to claim 1, 2 or 3,
**characterized in**
**that** the matching circuits (8, 9) respectively comprise a transformer and a quarter wave transmission line for adapting the wave impedances.

5. Power amplifier circuit (1) according to claim 1, 2 or 3,
**characterized in**
**that** the first matching circuit (8) comprises a quarter wave transmission line with a wave impedance of sqrt(Z₁*Z₃) and the second matching circuit (9) comprises a quarter wave transmission line with a wave impedance of sqrt(Z₂*Z₃) for adapting the wave impedances.

6. Power amplifier circuit (1) according to one of the claims 1 to 5,
**characterized in**
**that** the first wave impedance Z₁ is equal to the second wave impedance Z₂.

7. Power amplifier circuit (1) according to one of the claims 1 to 6,
**characterized in**
**that** the amplification path (3) comprises a second switching means (11) controlled by the controlling means (6) for connecting the amplification path (3) to the input terminal (2) in the amplifying mode and for disconnecting the amplification path (3) from the input terminal (2) in the bypassing mode.

8. Power amplifier circuit (1) according to one of the claims 1 to 7,
**characterized by**
a third switching means (12) controlled by the controlling means (6) for switching a power supply terminal (13) to the amplification means (4) in the amplifying mode.

9. Power amplifier circuit (1) according to one of the claims 1 to 8,
**characterized in**
**that** the amplification path (3) comprises a third matching circuit (14) for adapting the output wave impedance of the amplification means (4) to the third wave impedance Z₃ and for outputting the RF-signal to the output terminal (7).

10. Portable communication terminal for a wireless communication system, comprising a power amplifier circuit (1) according to one of the claims 1 to 9.

## Patentansprüche

1. Leistungsverstärkerschaltung (1) zum Verstärken eines Eingangs-HF-Signals, mit:
einem Eingangsanschluss (2), der eine erste Wellenimpedanz Z₁ zum Einspeisen eines HF-Signals hat,
einem Verstärkungsweg (3), der eine Verstärkungseinrichtung (4) zum Verstärken des Eingangs-HF-Signals aufweist,
einem Umleitungsweg (5) zum Umleiten um den Verstärkungsweg (3),
einem Steuerungsanschluss (6) zum Steuern des Betriebsmodus der Leistungsverstärkerschaltung (1) zwischen einem verstärkenden Modus und einem umleitenden Modus, so dass das Eingangs-HF-Signal entweder in dem verstärkenden Modus durch den Verstärkungsweg (3) verstärkt oder in dem umleitenden Modus durch den Umleitungsweg (5) umgeleitet wird, und
einem Ausgangsanschluss (7), der eine zweite Wellenimpedanz Z₂ zum Ausgeben des verstärkten oder umgeleiteten HF-Signals hat, wobei
der Umleitungsweg folgende Merkmale aufweist:
eine erste Anpassungsschaltung (8) zum Angleichen eines Eingangs-HF-Signals an eine dritte Wellenimpedanz Z₃,
eine zweite Anpassungsschaltung (9) zum Angleichen des an die dritte Wellenimpedanz Z₃ angeglichenen HF-Signals an die zweite Wellenimpedanz Z₂ und zum Ausgeben des an die zweite Wellenimpedanz Z₂ angeglichenen HF-Signals zu dem Ausgangsanschluss (7), und
einen ersten Schalter (10), der durch den Steuerungsanschluss (6) gesteuert wird, zum Ändern der dritten Impedanz Z₃, so dass der Umleitungsweg das Ausgangs-HF-Signal in dem verstärkenden Modus im Wesentlichen nicht beeinflusst, wobei der erste Schalter (10) so angeordnet ist, dass sich dieser in dem umleitenden Modus außerhalb des Signalwegs des Umleitungswegs befindet.

2. Leistungsverstärkerschaltung (1) nach Anspruch 1,
**dadurch gekennzeichnet,**
**dass** der erste Schalter (10) in dem verstärkenden Modus das an die dritte Wellenimpedanz Z₃ angeglichene HF-Signal auf Signalmasse schaltet und in dem umleitenden Modus zum Trennen des an die dritte Wellenimpedanz Z₃ angeglichenen HF-Signals von der Signalmasse schaltet.

3. Leistungsverstärkerschaltung (1) nach Anspruch 1 oder 2,
**dadurch gekennzeichnet,**
**dass** die dritte Wellenimpedanz Z₃ weit größer als die erste und die zweite Wellenimpedanz Z₁ und Z₂ ist.

4. Leistungsverstärkerschaltung (1) nach Anspruch 1, 2 oder 3,
**dadurch gekennzeichnet,**
**dass** die Anpassungsschaltungen (8, 9) jeweils einen Wandler und eine Viertelwellen-Übertragungsleitung zum Angleichen der Wellenimpedanzen aufweisen.

5. Leistungsverstärkerschaltung (1) nach Anspruch 1, 2 oder 3,
**dadurch gekennzeichnet,**
**dass** die erste Anpassungsschaltung (8) eine Viertelwellen-Übertragungsleitung mit einer Wellenimpedanz von Quadratwurzel(Z₁*Z₃) und die zweite Anpassungsschaltung (9) eine Viertelwellen-Übertragungsleitung mit einer Wellenimpedanz von Quadratwurzel(Z₂*Z₃) zum Angleichen der Wellenimpedanzen aufweist.

6. Leistungsverstärkerschaltung (1) nach einem der Ansprüche 1 bis 5,
**dadurch gekennzeichnet,**
**dass** die erste Wellenimpedanz Z₁ gleich der zweiten Wellenimpedanz Z₂ ist.

7. Leistungsverstärkerschaltung (1) nach einem der Ansprüche 1 bis 6,
**dadurch gekennzeichnet,**
**dass** der Verstärkungsweg (3) eine zweite Schalteinrichtung (11), die durch die Steuereinrichtung (6) gesteuert wird, zum Verbinden des Verstärkungswegs (3) mit dem Eingangsanschluss (2) in dem verstärkenden Modus und zum Trennen des Verstärkungswegs (3) von dem Eingangsanschluss (2) in dem umleitenden Modus aufweist.

8. Leistungsverstärkerschaltung (1) nach einem der Ansprüche 1 bis 7,
**gekennzeichnet durch**
eine dritte Schalteinrichtung (12), die **durch** die Steuereinrichtung (6) gesteuert wird, zum Schalten eines Leistungsversorgungsanschlusses (13) zu der Verstärkungseinrichtung (4) in dem verstärkenden Modus.

9. Leistungsverstärkerschaltung (1) nach einem der Ansprüche 1 bis 8,
**dadurch gekennzeichnet,**
**dass** der Verstärkungsweg (3) eine dritte Anpassungsschaltung (14) zum Angleichen der Ausgangswellenimpedanz der Verstärkungseinrichtung (4) an die dritte Wellenimpedanz Z₃ und zum Ausgeben des HF-Signals zu dem Ausgangsanschluss (7) aufweist.

10. Tragbares Kommunikationsendgerät fiir ein drahtloses Kommunikationssystem, mit einer Leistungsverstärkerschaltung (1) nach einem der Ansprüche 1 bis 9.

## Revendications

1. Circuit amplificateur de puissance (1) pour amplifier un signal RF d'entrée, comportant
une borne d'entrée (2) caractérisant une première impédance d'onde Z₁ pour entrer un signal RF,
un trajet d'amplification (3) comportant un moyen d'amplification (4) pour amplifier le signal RF d'entrée,
un trajet de contournement (5) pour contourner le trajet d'amplification (3),
une borne de contrôle (6) pour contrôler le mode de fonctionnement du circuit amplificateur de puissance (1) entre un mode d'amplification et un mode de contournement, de sorte que le signal RF d'entrée est soit amplifié par le trajet d'amplification (3) dans le mode d'amplification ou contourné par le trajet de contournement (5) dans le mode de contournement, et
une borne de sortie (7) caractérisant une seconde impédance d'onde Z₂ pour délivrer le signal RF amplifié ou contourné, moyennant quoi
le trajet de contournement comporte
un premier circuit d'adaptation (8) pour adapter un signal RF d'entrée à une troisième impédance d'onde Z₃,
un second circuit d'adaptation (9) pour adapter le signal RF adapté à la troisième impédance d'onde Z₃ à la seconde impédance d'onde Z₂ et pour délivrer le signal RF adapté à la seconde impédance d'onde Z₂ à la borne de sortie (7), et
un premier commutateur (10) contrôlé par la borne de contrôle (6) pour modifier la troisième impédance Z₃, de sorte que le trajet de contournement n'affecte pas sensiblement le signal RF de sortie dans le mode d'amplification, moyennant quoi le premier commutateur (10) est disposé de sorte qu'il se trouve à l'extérieur du trajet de signal du trajet de contournement dans le mode de contournement.

2. Circuit amplificateur de puissance (1) selon la revendication 1, **caractérisé en ce que** le premier commutateur (10) commute le signal RF adapté à la troisième impédance d'onde Z₃ à la terre de signal dans le mode d'amplification et pour déconnecter le signal RF adapté à la troisième impédance d'onde Z₃ depuis la terre de signal dans le mode de contournement.

3. Circuit amplificateur de puissance (1) selon la revendication 1 ou 2, **caractérisé en ce que** la troisième impédance d'onde Z₃ est beaucoup plus grande que la première et la seconde impédance d'onde Z₁ et Z₂.

4. Circuit amplificateur de puissance (1) selon la revendication 1, 2 ou 3, **caractérisé en ce que** les circuits de correspondance (8, 9) comportent respectivement un transformateur et une ligne de transmission quart d'onde pour adapter les impédances d'onde.

5. Circuit amplificateur de puissance (1) selon la revendication 1, 2 ou 3**, caractérisé en ce que** le premier circuit d'adaptation (8) comporte une ligne de transmission quart d'onde avec une impédance d'onde de sqrt(Z₁*Z₃) et le second circuit d'adaptation (9) comporte une ligne de transmission quart d'onde avec une impédance d'onde de sqrt(Z₂*Z₃) pour adapter les impédances d'onde.

6. Circuit amplificateur de puissance (1) selon l'une des revendications 1 à 5, **caractérisé en ce que** la première impédance d'onde Z₁ est égale à la seconde impédance d'onde Z₂.

7. Circuit amplificateur de puissance (1) selon l'une des revendications 1 à 6, **caractérisé en ce que** le trajet d'amplification (3) comprend un second moyen de commutation (11) contrôlé par le moyen de contrôle (6) pour relier le trajet d'amplification (3) à la borne d'entrée (2) dans le mode d'amplification et pour déconnecter le trajet d'amplification (3) de la borne d'entrée (2) dans le mode de contournement.

8. Circuit amplificateur de puissance (1) selon l'une des revendications 1 à 7, **caractérisé par** un troisième moyen de commutation (12) contrôlé par le moyen de contrôle (6) pour commuter une borne d'alimentation (13) au moyen d'amplification (4) dans le mode d'amplification.

9. Circuit amplificateur de puissance (1) selon l'une des revendications 1 à 8, **caractérisé en ce que** le trajet d'amplification (3) comprend le troisième circuit d'adaptation (14) pour adapter l'impédance d'onde de sortie des moyens d'amplification (4) à la troisième impédance d'onde Z₃ et pour délivrer le signal RF à la borne de sortie (7).

10. Terminal de communication portable pour un système de communication sans fil, comportant un circuit amplificateur de puissance (1) selon l'une des revendications 1 à 9.
